(19) Europäisches Patentamt
European Patent Office
Office européen des brevets

(11) **EP 0 803 976 A2**

(12) **EUROPEAN PATENT APPLICATION**

(43) Date of publication:
29.10.1997 Bulletin 1997/44

(51) Int. Cl.⁶: **H03F 3/45**

(21) Application number: 97301521.7

(22) Date of filing: 06.03.1997

(84) Designated Contracting States:
AT DE ES FR GB IT

(30) Priority: 25.04.1996 GB 9608623

(71) Applicant:
PLESSEY SEMICONDUCTORS LIMITED
Swindon, Wiltshire SN2 2QW (GB)

(72) Inventor: Clarke, David Stuart
Kingsdown, Wiltshire, SN2 6TZ (GB)

(74) Representative: Waters, Jeffrey
The General Electric Company, p.l.c.
GEC Patent Department
Waterhouse Lane
Chelmsford, Essex CM1 2QX (GB)

(54) **Amplifier**

(57) An amplifier, such as an operational amplifier, has a high differential gain stage despite low supply voltage. By duplicating the conventional input stage (Q1 to Q4), in another stage (Q11 to Q15), making that pair of voltage buffers so formed a differential pair, and arranging the output transistors (Q5,Q15) themselves into a differential pair, high gains are possible even though the PNP transistors (Q3,Q13,Q17) have a low Early voltage.

Fig 4

## Description

This invention relates to amplifiers.

The invention particularly relates to operational amplifiers in phase-locked loops used for synthesizing RF channel frequencies in a transceiver, especially a transceiver used in WLAN (Wireless Local Area Network) applications.

One application of the latter is portable terminals such as lap-top computers, point-of-sale terminals, which communicate with a host processor, wherein the transceiver may be accommodated in a standard PC expansion card such as a PCMCIA (Personal Computer Memory Card International Association)-sized card. However, this has a standard voltage supply of 3.0 volt ± 10%, and it is difficult to realise the sufficiently large gain needed to supply the large output currents required and still attaining "rail to rail" swing at a reasonable cost.

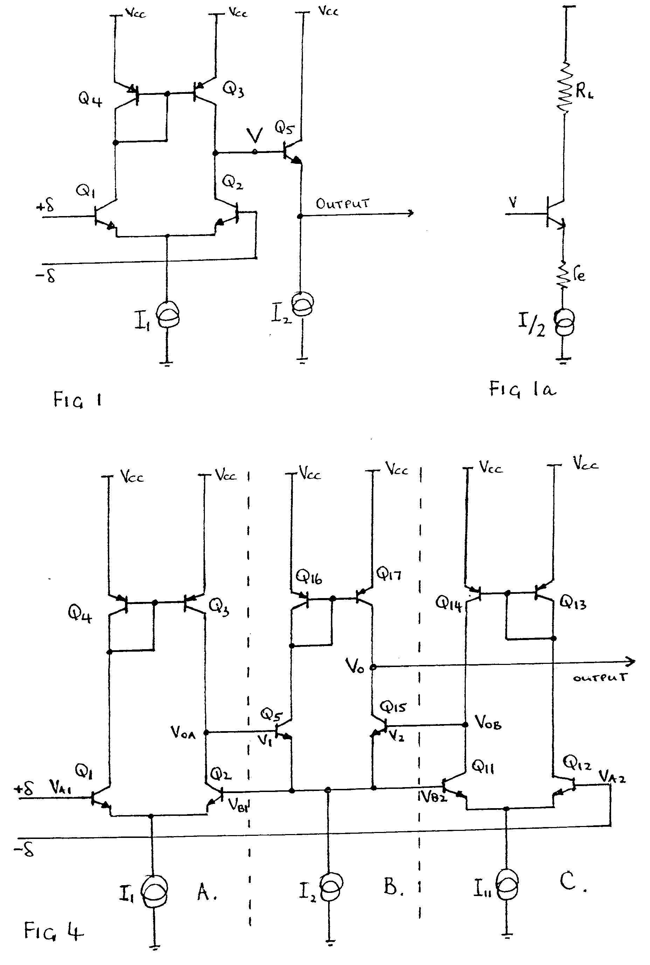

For example, a typical input stage of an operational amplifier is shown in Figure 1. The input stage is a voltage buffer with high input impedance and low output impedance.

The collector load of the differential pair of transistors Q1, Q2 is a current mirror Q3, Q4, where Q4, connected as a diode, forms the reference current. Current $I_1$ biases the differential pair. Output V of the input stage is fed to driver stage Q5 biased by current source $I_2$.

The gain of the input stage of Figure 1 ($V/\delta$ where $\delta$ is the differential input voltage and V is the voltage at the output of the differential pair, assuming the circuit is balanced) can be deduced by reference to single ended version of Figure 1a (note that current is I/2)

$$\text{Gain Avd} = \frac{R_L}{r_e}$$

$$\text{Now } r_e = \frac{kT}{q(I/2)}$$

k is Boltzman's constant

T is the absolute temperature

q is the electron charge

It turns out in Figure 1 that, for a.c. signals, $R_L$ can be considered as being made up of Q2 and Q3 collector impedances in parallel. The collector impedance of Q2 is given by

$$\frac{V_A(N)}{I/2}$$

Where $V_A$ (N) is the Early voltage of the NPN transistor. The collector impedance of Q3 is given by

$$\frac{V_A(P)}{I/2}$$

where $V_A$ (P) is the Early voltage of the PNP transistor.

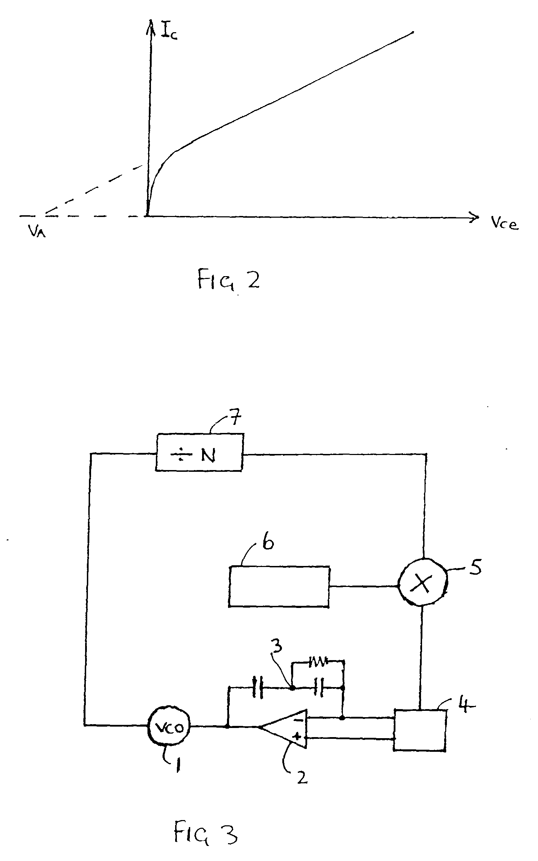

PNPs have a low Early voltage (around 10 volts) compared with 35 volts for NPN transistors. The Early voltage is illustrated in Figure 2, for PNP transistor Q3.

Accordingly, $R_L$ is the parallel combination of the collector impedances (product divided by sum) i.e.

$$_L = \frac{V_A(N).V_A(P)}{V_A(N)+V_A(P)} \cdot \frac{2}{I} = \frac{2}{I} \cdot V_A(\text{eff}$$

$V_A$ (eff) is thus the effective Early voltage for the differential input stage of Figure 1. Thus,

$$Avd(unloaded) = \frac{2}{I} V_A(eff) \cdot \frac{q(I/2)}{kT}$$

$$= \frac{q}{kT} V_A(eff)$$

The low value of $V_A(eff)$, lower even than $V_A(P)$, limits the overall gain Avd possible.

The invention provides an amplifier which comprises a first voltage buffer having a relatively high input impedance and a relatively low output impedance, the output being connected to the control electrode of a first transistor having a first output electrode, a second voltage buffer having a relatively high input impedance and a relatively low output impedance, the output being connected to the control electrode of a second transistor having a first output electrode, the voltage buffers being arranged as a differential pair, the inputs forming the inputs of the amplifier, and the first and second transistors being arranged as a differential pair, second output electrodes of the transistors being connected together, and at least one of the first output electrodes being connected as the output of the amplifier.

This configuration permits high gain to be achieved with a low supply voltage in a bipolar implementation even if PNP transistors are included.

The invention will now be described by way of example with reference to the accompanying drawings, in which:

Figure 1 shows the circuit of a conventional input stage;

Figure 1a shows a single transistor amplifier in common emitter mode;

Figure 2 illustrates the Early voltage of one of the transistors of the circuit of Figure 1;

Figure 3 is a block circuit diagram of a phase-locked loop of a synthesizer constructed in accordance with the invention;

Figure 4 shows part of the circuit of an operational amplifier of the phase-locked loop of Figure 3; and

Figure 5 shows a graph of the voltage gain of the circuit of Figure 1 and the voltage gain of the circuit of Figure 4.

Referring to Figure 3, the phase-locked loop, forming the local oscillator, is for synthesizing RF frequency channels in a transceiver used in a WLAN application and housed in a PCMCIA-sized card for accommodation in a portable terminal in order to transmit to a host processor. The RF channels (which may be in the range 2.4 to 2.5 GHz) are synthesized at the output of a voltage controlled oscillator (VCO) 1 which receives its control voltage from the operational amplifier 2 connected from the inverting input with a third order filter 3 in a feedback mode. The inverting input of the operational amplifier is connected to a charge pump 4 which is controlled by a phase detector 5. The latter compares the phase of a reference oscillator 6 with that of the output of the voltage controlled oscillator after division by N in a counter 7. The divide-by ratio of the counter may be incremented or decremented in order to allow the loop to lock to a different output frequency. The charge pump 4 supplies pulses to the inventing input of the operational amplifier 2 which vary in width and polarity according to the phase error but are always of constant amplitude. A suitable charge pump is described in GB-B-2 249 443. The non-inverting input is set at a reference potential.

In the above circuit, a high gain is needed in the operational amplifier 2 since the pulses provided by the charge pump 4 must be cancelled as far as possible at the inverting input by currents supplied from the output around the loop filter in order that the offset current entering the inverting input may be as small as possible and the inverting input as near as possible to a virtual earth. The current supplied by the charge pump may be generated at the rate of 1 MHz, the pulses may vary in duration from 0 to 700 ns, and the amplitude may be 1 mA (positive or negative). In addition, to provide a reasonable tuning range of the phase-locked loop, the output of the operational amplifier needs to be able to swing almost rail to rail between the supply voltage which, because of the 3 volt ± 10% restriction, may be as low as 2.7 volts.

In accordance with the invention, the conventional input stage of Figure 1 is duplicated with another input stage denoted by the parts Q11 to Q15 and bias current source $I_{11}$, matching the components Q1 to Q5 and $I_1$ of the known input stage. The differential input is connected to the bases of transistors Q1 and Q12, and Q5 and Q15 are themselves connected to form a differential pair with current mirror Q16, Q17 in the collector loads, Q16 being connected as a diode and Q17 forming the output.

$$Avd = \frac{qV_A(eff)}{kT} = \frac{V_0}{V_1 - V_2}$$

The output $V_o$ is not the output of the operational amplifier but the output of the input stage of the operational amplifier. The operational amplifier also includes a driver stage and output stage.

The overall gain of the input stage of the invention can be calculated as follows. For stage A, the gain Avd is given by

$$Avd = \frac{q}{kT} V_A(eff) = \frac{V_{OA}}{(V_{A1} - V_{B1})}$$

$$\text{Hence } V_{OA} = \frac{qV_A(eff)}{kT}(V_{A1} - V_{B1})$$

The gain Avd for stage B, is similarly given by

$$Avd = \frac{q}{kT} V_A(eff) = \frac{V_{OB}}{V_{A2} - V_{B2}}$$

$$\text{Hence } V_{OB} = \frac{q}{kT} V_A(eff)(V_{A2} - V_{B2})$$

The gain for stage C is given by

$$Avd = \frac{qV_A(eff)}{kT} = \frac{V_0}{V_1 - V_2}$$

$$\text{Hence } V_0 = \frac{qV_A(eff)}{kT}(V_1 - V_2)$$

Remembering that $V_{B1} = V_{B2} = V_B$ and $V_{OA} = V_1$, $V_{OB} = V_2$, the overall gain $A_V$(total) is thus

$$A_V(total) = \frac{V_0}{V_{A1} - V_{A2}} = \frac{qV_A(eff)}{kT} \frac{(V_1 - V_2)}{(V_{A1} - V_{A2})}$$

$$= \frac{qV_A(eff)}{kT(V_{A1} - V_{A2})} \cdot \frac{q V_A(eff)}{kT}(V_{A1} - V_{B1} - V_{A2} + V_{B2})$$

$$= \left[\frac{q}{kT} \cdot V_A(eff)\right]^2$$

This analysis assumes that the load on the output collectors is the same for stages A, B and C.

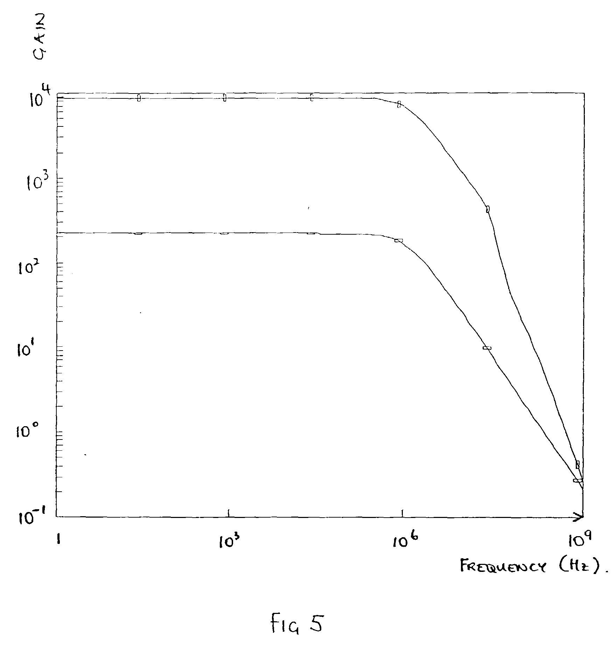

Incorporating the voltage buffers Q1 to Q4 and Q11 to Q14 on the input to the differential pairs Q5, Q15 to Q17 means that about $10^4$ gain can be achieved from this first stage, compared to only about $10^2$ for the stage of Figure 1. The graph of Figure 5 shows the effect of this improvement in voltage gain. The lower curve is the conventional stage of Figure 1 and the upper curve is the improved stage.

This improved gain compensates for the lower value of $V_A(eff)$ which stems from the low Early voltage of the PNP transistors Q3, Q13, and Q17 which, since they are in effect in the collector circuit of the respective differential pairs Q1, Q2, Q11, Q12 and Q5, Q15, restrict the gain from those respective differential stages by virtue of reducing the impedance in the collector arm. The output voltage can swing almost rail to rail with properly designed driver and output stages.

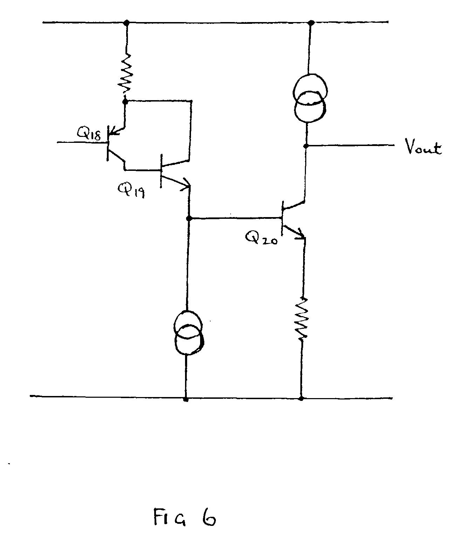

Figure 6 shows a suitable driver (Q18,19) and output stage (Q20). The output could drive the varicap of a voltage controlled oscillator.

In practice the circuit of Figure 4 could have emitter degeneration in the PNP transistors, protection circuits on the bases of transistors Q5, Q15 to prevent Q2, Q11 going into reverse bias (this could exceed Vce (saturation), and inverse mode operation could take place.) The current sources could be transistors derived from a band gap. Also, some compensation capacitance could also be applied.

Of course, variations may be made without departing from the scope of the invention. Thus, for example, the invention is applicable to operational amplifiers used other than in phase-locked loops, and to amplifiers in which the feedback is not provided. Equally, the amplifier could be provided with differential outputs instead of the single output shown.

## Claims

1. An amplifier which comprises a first voltage buffer having a relatively high input impedance and a relatively low output impedance, the output being connected to the control electrode of a first transistor having a first output electrode, a second voltage buffer having a relatively high input impedance and a relatively low output impedance, the output being connected to the control electrode of a second transistor having a first output electrode, the voltage buffers being arranged as a differential pair, the inputs forming the inputs of the amplifier, and the first and second transistors being arranged as a differential pair, second output electrodes of the transistors being connected together, and at least one of the first output electrodes being connected as the output of the amplifier.

2. An amplifier as claimed in claim 1, in which each voltage buffer comprises a differential pair of transistors having a current mirror in the collector electrodes.

3. An amplifier as claimed in claim 2, in which the current mirror consists of PNP transistors.

4. An amplifier as claimed in any one of claims 1 to 3, in which collectors form the first output electrodes of the first and second transistors and emitters form the second output electrodes of those transistors.

5. A phase-locked loop including an amplifier as claimed in any one of claims 1 to 4 as the loop amplifier.

6. A transceiver having the phase-locked loop of claim 5 for synthesizing RF channels.

FIG 1

FIG 1a

FIG 4

FIG 2

FIG 3

FIG 5

FIG 6